# EUROPEAN PATENT APPLICATION

(11) **EP 1 757 389 A1**
(43) Date of publication of application: **28.02.2007**
(21) Application number: 05814674.7
(22) Date of filing: 06.12.2005
(51) Int. Cl.: B23B 27/14, B23B 51/00, B23C 5/16, C23C 16/38

(54) **SURFACE-COATED CUTTING TOOL**

(30) Priority: 22.12.2004 JP 2004371920; 24.12.2004 JP 2004374535
(71) Applicant: Sumitomo Electric Hardmetal Corp., Itami-shi, Hyogo 664-0016 (JP)
(72) Inventor: IMAMURA, Shinya SUMITOMO EL. HARDMETAL CORP., Hyogo 6640016 (JP); TAKANASHI, Norihiro SUMITOMO EL. HARDMETAL CORP., Hyogo 6640016 (JP); ITOH, Minoru SUMITOMO EL. HARDMETAL CORP., Hyogo 6640016 (JP); OKADA, Yoshio SUMITOMO EL. HARDMETAL CORP., Hyogo 6640016 (JP); OMORI, Naoya SUMITOMO EL. HARDMETAL CORP., Hyogo 6640016 (JP)
(74) Representative: Grünecker, Kinkeldey, Stockmair & Schwanhäusser Anwaltssozietät
(86) International application number: PCT/JP2005/022343
(87) International publication number: WO 2006/067956

(57) **Abstract**

The present invention is directed to a surface-coated cutting tool including a substrate and a coating layer formed on the substrate. The coating layer includes a first coating layer composed of titanium boronitride or titanium boron-oxynitride and a second coating layer formed from at least one selected from the group consisting of aluminum oxide, zirconium oxide, hafnium oxide and a solid solution mainly including two or more of these components. The first coating layer is located directly under the second coating layer, between the substrate and the second coating layer. The second coating layer has compressive stress at least in an area involved with cutting.

## Description

### Technical Field

The present invention relates to a cutting tool such as a drill, an end mill, an insert for milling or turning, a metal saw, a gear cutting tool, a reamer, a tap, or an insert for crankshaft pin milling, and more particularly to a surface-coated cutting tool on which surface a coating layer for improving characteristic such as toughness, wear resistance and the like is formed.

### Background Art

A surface-coated cutting tool in which various coating layers are formed on a surface of a substrate in order to improve toughness and wear resistance of the cutting tool has conventionally been used. Recently, forming a coating layer composed of an oxide represented by aluminum oxide as an outermost layer has attracted attention. This is because the oxide has excellent oxidation resistance and stability at high temperature, prevents adhesion to a work material, and attains good wear resistance.

If the coating layer composed of the oxide is formed as the outermost layer and particularly if aluminum oxide is employed as the oxide, the tool as a whole exhibits a color close to black. This is not advantageous in terms of design of appearance, and it has not been easy to determine a used state of the tool (particularly, which cutting-edge portion has already been used).

Accordingly, it has been proposed to solve the problem by forming a gold TiN layer under an aluminum oxide layer having a relatively small thickness so as to allow the TiN layer to be observed through the aluminum oxide layer, whereby the tool as a whole has yellowish color (Japanese Patent Laying-Open No. 07-227703 (Patent Document 1)).

According to this proposal, though some effect can be expected from a point of view of recognition of the used state, adhesion strength between the aluminum oxide layer and the TiN layer is not sufficient and the aluminum oxide layer readily peels off.

Meanwhile, as an attempt to solve the problem of peeling, it has been proposed to form a titanium boronitride layer or a titanium boron-oxynitride layer as an underlying layer for the oxide layer (International Publication No. 03/061885 Pamphlet (Patent Document 2)). Though this proposal can solve the problem of peeling described above, such an oxide layer is poor in toughness.
Patent Document 1: Japanese Patent Laying-Open No. 07-227703
Patent Document 2: International Publication No. 03/061885 Pamphlet

### Disclosure of the Invention

### Problems to be Solved by the Invention

The present invention was made to solve the above-described problems. An object of the present invention is to provide a surface-coated cutting tool having an oxide coating layer attaining excellent wear resistance and toughness.

### Means for Solving the Problems

In order to solve the above-described problems, the present inventors have conducted dedicated study, and conceived that the oxide coating layer according to the conventional art (Patent Document 2) is formed on the titanium boronitride layer or the titanium boron-oxynitride layer with chemical vapor deposition (CVD), and therefore the oxide coating layer has tensile residual stress, which may lead to lower toughness. The present invention was completed based on this concept and further study.

The present invention is directed to a surface-coated cutting tool including a substrate and a coating layer formed on the substrate. The coating layer includes a first coating layer composed of titanium boronitride or titanium boron-oxynitride, and a second coating layer formed from at least one selected from the group consisting of aluminum oxide, zirconium oxide, hafnium oxide and a solid solution mainly including two or more of these components. The first coating layer is located directly under the second coating layer, between the substrate and the second coating layer, and the second coating layer has compressive stress at least in an area involved with cutting.

The coating layer of the surface-coated cutting tool may have a third coating layer between the substrate and the first coating layer, and the third coating layer may be formed from a compound of at least one element selected from the group consisting of IVa-group elements (Ti, Zr, Hf, and the like), Va-group elements (V, Nb, Ta, and the like) and VIa-group elements (Cr, Mo, W, and the like) in periodic table, Al, and Si and at least one element selected from the group consisting of carbon, nitrogen, oxygen, and boron.

The first coating layer may be composed of titanium boronitride expressed as TiB_{X}N_{Y}, where X and Y represent atomic % and relation of 0.001<X/(X+Y)<0.04 is established.

The first coating layer may be composed of titanium boron-oxynitride expressed as TiB_{X}N_{Y}O_{z}, where X, Y and Z represent atomic % and relation of 0.0005<X/(X+Y+Z)<0.04 and 0<Z/(X+Y+Z)<0.5 is established.

The compressive stress may be compressive stress of which absolute value is at least 0.2GPa.

The first coating layer may have a thickness of at least 0.1µm to at most 3µm, and the coating layer may have a thickness of at least 0.2µm to at most 30µm.

The third coating layer may include a titanium carbonitride layer formed with MT-CVD, and the second coating layer may be composed of α-aluminum oxide.

The coating layer may further include a fourth coating layer, and the fourth coating layer may be formed on the second coating layer, in a portion excluding at least an area involved with cutting.

The substrate may be formed from any one of cemented carbide, cermet, high-speed steel, ceramics, sintered cubic boron nitride, sintered diamond, sintered silicon nitride, and a mixture of aluminum oxide and titanium carbide, and the surface-coated cutting tool may be any one of a drill, an end mill, an insert for milling or turning, a metal saw, a gear cutting tool, a reamer, a tap, and an insert for crankshaft pin milling.

### Effects of the Invention

Structured as described above, the surface-coated cutting tool according to the present invention successfully achieves both excellent wear resistance and toughness by having compressive stress at least in an area involved with cutting, of the second coating layer particularly formed from an oxide. In addition, as color state of the first coating layer can be observed through the second coating layer, yellowish appearance can be given and the used state of the tool (which cutting-edge portion has already been used) can thus readily be recognized.

### Best Modes for Carrying Out the Invention

### <Surface-Coated Cutting Tool>

The surface-coated cutting tool according to the present invention includes the substrate and the coating layer formed on the substrate. The surface-coated cutting tool according to the present invention having such a basic structure is extremely useful as a drill, an end mill, an insert for milling or turning, a metal saw, a gear cutting tool, a reamer, a tap, or an insert for crankshaft pin milling.

### <Substrate>

A conventionally known material for the substrate of the cutting tool may be used as the substrate for the surface-coated cutting tool according to the present invention, without particularly limited. Examples of such a substrate include cemented carbide (for example, WC based cemented carbides composed ofWC alone or combination of WC and Co and/or carbonitride of Ti, Ta, Nb, or the like), cermet (mainly composed of TiC, TiN, TiCN, or the like), high-speed steel, ceramics (titanium carbide, silicon carbide, silicon nitride, aluminum nitride, aluminum oxide, or the like), sintered cubic boron nitride, sintered diamond, sintered silicon nitride, or a mixture composed of aluminum oxide and titanium carbide. In the case of employing the cemented carbide as the substrate, the effect of the present invention is obtained even when the cemented carbide contains free carbon or an abnormal phase called ε phase in its texture.

It is noted that the surface of the substrate may be reformed. For example, in the case of the cemented carbide, a beta (β) removal layer may be formed on its surface, or in the case of the cermet, a surface-hardened layer may be formed. Even if the surface is reformed in such a manner, the effect of the present invention is still obtained.

### <Coating Layer>

The coating layer formed on the substrate of the surface-coated cutting tool according to the present invention includes at least the first coating layer and the second coating layer which will be described later. The first coating layer is formed directly under the second coating layer, between the substrate and the second coating layer which will be described later.

Such a coating layer may include the third coating layer and the fourth coating layer in addition to these first and second coating layers. The third coating layer is located between the substrate and the first coating layer, and the fourth coating layer is formed on the second coating layer.

The coating layer preferably has a thickness of at least 0.2µm to at most 30µm. The upper limit of the thickness of the coating layer is preferably at most 20µm and more preferably at most 15µm. The lower limit of the thickness of the coating layer is preferably at least 0.3µm and more preferably at least 1µm. If the thickness is smaller than 0.2µm, characteristics such as wear resistance, toughness, and the like may not sufficiently be exhibited. Meanwhile, if the thickness exceeds 30µm, there is not much difference in the effect, and it is economically disadvantageous. These coating layers will be described hereinafter in further detail.

### <First Coating Layer>

The first coating layer according to the present invention is composed of titanium boronitride (TiBN) or titanium boron-oxynitride (TiBNO), and located directly under the second coating layer, between the substrate and the second coating layer as described above. The first coating layer has excellent adhesiveness to the second coating layer, thereby attaining a function to prevent the second coating layer from peeling off.

As the first coating layer itself exhibits yellow or gold color, this color is observed through the second coating layer. Accordingly, yellowish appearance can be provided to the tool, which facilitates recognition as to whether the cutting-edge portion of the tool has been used or not. This is because, when the cutting-edge portion is used, a portion of which color has been changed to black or the like is created around the used portion.

Preferably, the first coating layer is composed of titanium boronitride expressed particularly as TiB_{X}N_{Y}, where X and Y represent atomic % and relation of 0.001<X/(X+Y)<0.04 is established. Therefore, adhesiveness to the second coating layer is particularly excellent.

If X/(X+Y) is not larger than 0.001, adhesiveness to the second coating layer may be poor. On the other hand, if X/(X+Y) is not smaller than 0.04, reactivity to the work material becomes higher. In such a case, if the first coating layer is exposed at the surface of the tool, the first coating layer reacts with the work material, and resultant adhesive substance firmly adheres to the cutting edge of the tool, which may impair appearance of the work material. More preferably, relation of 0.003<X/(X+Y)<0.02 is established. It is noted that the atomic ratio between Ti and the total of BN in the formula above does not necessarily have to be 1:1 as conventionally known.

Preferably, the first coating layer is composed of titanium boron-oxynitride expressed particularly as TiB_{X}N_{Y}O_{Z}, where X, Y and Z represent atomic % and relation of 0.0005 < X/(X+Y+Z) < 0.04 and 0<Z/(X+Y+Z) < 0.5 is established. Therefore, adhesiveness to the second coating layer is particularly excellent.

If X/(X+Y+Z) is not larger than 0.0005, adhesiveness to the second coating layer may be poor. On the other hand, if X/(X+Y+Z) is not smaller than 0.04, reactivity to the work material becomes higher. In such a case, if the first coating layer is exposed at the surface of the tool, the first coating layer reacts with the work material, and resultant adhesive substance firmly adheres to the cutting edge of the tool, which may impair appearance of the work material. More preferably, relation of 0.003<X/(X+Y+Z)<0.02 is established.

Meanwhile, if Z/(X+Y+Z) is not smaller than 0.5, toughness and chipping resistance are lowered, although hardness of the layer is increased. More preferably, relation of 0.0005<Z/(X+Y+Z)<0.3 is established. It is noted that the atomic ratio between Ti and the total of BNO in the formula above does not necessarily have to be 1:1 1 as conventionally known.

The first coating layer preferably has a thickness of at least 0.1µm to at most 3µm. The upper limit of the thickness of the first coating layer is preferably at most 2µm and the lower limit thereof is preferably at least 0.2µm. If the thickness is smaller than 0.1µm, an effect to improve adhesiveness to the second coating layer may not sufficiently be exhibited. Meanwhile, if the thickness exceeds 3µm, there is not much difference in the effect, and it is economically disadvantageous.

The first coating layer may be formed directly on the substrate, or if the third coating layer which will be described later is formed, the first coating layer may be formed on the third coating layer. Here, any method such as conventionally known chemical vapor deposition (CVD) and physical vapor deposition (PVD) may be adopted as a method of forming the first coating layer (forming method), and the forming method is not particularly limited.

### <Second Coating Layer>

The second coating layer according to the present invention is implemented as a single layer or a plurality of layers, by at least one selected from the group consisting of aluminum oxide, zirconium oxide, hafnium oxide and a solid solution mainly including two or more of these components, and the second coating layer is located directly on the first coating layer. The second coating layer has such excellent characteristics as excellent oxidation resistance and stability at high temperature, good wear resistance, and low reactivity to the work material. It is noted that the solid solution contains two or more of the three types of oxides above, and normally composed solely of two or more oxides. Meanwhile, as mixing of other components is not excluded, the expression "mainly including two or more of these components" has been used.

The second coating layer exhibits excellent toughness by having compressive stress at least in an area involved with cutting, thus attaining excellent chipping resistance. The compressive stress used herein represents one type of internal stress (intrinsic strain) present in a coating layer, and is expressed by a "-" (minus) numeric value (unit: "GPa" in the present invention). Therefore, the concept "large compressive stress" indicates that the absolute value of the numeric value above is large, whereas the concept "small compressive stress" indicates that the absolute value of the numeric value above is small. In this connection, tensile stress represents one type of internal stress (intrinsic strain) present in a coating layer, and is expressed by a "+" (plus) numeric value. When the second coating layer is formed with CVD as will be described later, tensile stress remains. Therefore, the present invention is characterized by providing compressive stress by carrying out blasting treatment or the like so as to release tensile stress.

Here, the area involved with cutting refers to an area substantially involved with cutting of the work material, and specifically refers to a region extending from the cutting-edge portion toward a rake face direction and a flank face direction each with a width of at least 0.01mm. The width is generally set to at least 0.05mm, and more generally to at least 0.1mm in many cases. The term "cutting-edge portion" above refers to a concept encompassing not only a portion corresponding to the ridge at which the rake face which is the surface in contact with chips of the work material in the tool and the flank face which is the surface in contact with the work material itself intersect with each other (sharp edge) but also a portion obtained by subjecting the sharp edge to cutting-edge treatment so as to have curve (R) (what is called a round-type honed edge), a beveled portion (what is called a chamfer-type honed edge), and a portion subjected to combined cutting-edge treatment and beveling.

The reason why at least the area involved with cutting in the second coating layer has compressive stress is that this area comes in direct contact with the work material during the cutting process and therefore it is considered as the area most involved with chipping resistance. Therefore, so long as the area involved with cutting has compressive stress, a portion other than this area may have compressive stress or the entire second coating layer may have compressive stress.

The method of providing such compressive stress is not particularly limited. For example, if the second coating layer is formed with CVD as will be described later, compressive stress can be provided by subjecting the second coating layer to blasting treatment, shot peening treatment, barreling treatment, brushing treatment, ion implantation treatment, and the like after it is formed. On the other hand, if the second coating layer is formed with PVD, compressive stress has already been provided at the time of forming, and therefore, the treatment as above is not necessary. Even in such a case, however, the treatment as above may be performed as desired.

The absolute value of compressive stress is set preferably to at least 0.2GPa, and more preferably to at least 0.5GPa. If the absolute value is lower than 0.2GPa, sufficient toughness may not be obtained. Meanwhile, though a larger absolute value is preferred from a point of view of providing toughness, the second coating layer itself may peel off if the absolute value exceeds 8GPa, which is not preferred.

The second coating layer is preferably formed from aluminum oxide among the oxides above, and particularly preferably formed from α-aluminum oxide. This is because α-aluminum oxide particularly has excellent stability at high temperature as well as high hardness, thereby exhibiting excellent wear resistance, and because α-aluminum oxide hardly reacts with the work material.

The second coating layer has a thickness (the total thickness if the second coating layer is formed by a plurality of layers) of preferably at least 0.1µm to at most 20µm. The upper limit of the thickness of the second coating layer is preferably at most 10µm and the lower limit thereof is preferably at least 0.2µm. If the thickness is smaller than 0.1µm, an effect to improve wear resistance may not sufficiently be exhibited. Meanwhile, if the thickness exceeds 20µm, there is not much difference in the effect, and it is economically disadvantageous.

The second coating layer is formed directly on the first coating layer. Any method such as conventionally known chemical vapor deposition (CVD) and physical vapor deposition (PVD) may be adopted as a method of forming the second coating layer (forming method), and the forming method is not particularly limited.

The compressive stress may be measured with any method. For example, the compressive stress can be measured with a sin²ψ method using an X-ray stress measurement apparatus. Specifically, the compressive stress can be measured in such a manner that stress at any 10 points included in the area involved with cutting (these points are preferably selected at a distance from each other by at least 0.5mm, in order to represent the stress in that area) is measured with the sin²ψ method, and the average thereof is calculated.

The sin²ψ method using an X-ray is widely used as a method of measuring residual stress in a polycrystalline material, and the method described in detail on pages 54-66 of "X-ray Stress Measurement" (The Society of Materials Science, Japan, 1981, published by Yokendo Co., Ltd.) may be used.

Compressive stress can also be measured utilizing a method using Raman spectroscopy. The Raman spectroscopy is advantageous in its ability of local measurement, that is, measurement of a narrow area such as an area having a spot diameter of 1µm. For measuring the compressive stress using the Raman spectroscopy, for example, a method described on pages 264-271 of "Technique for Evaluating Dynamic Property of Thin Film" (Sipec, published in 1992) can be adopted, although it is a common method.

Alternatively, compressive stress can also be measured utilizing synchrotron radiation, in which case distribution of compressive stress in a direction of thickness of the coating layer can advantageously be found.

### <Third Coating Layer>

The third coating layer according to the present invention is formed between the substrate and the first coating layer as desired, and attains the function to prevent the first coating layer from peeling off by having excellent adhesiveness to both of the substrate and the first coating layer.

The third coating layer is formed as a single layer or a plurality of layers, from a compound of at least one element selected from the group consisting of the IVa-group elements, the Va-group elements and the VIa-group elements in the periodic table, Al, and Si and at least one element selected from the group consisting of carbon, nitrogen, oxygen, and boron.

Examples of compounds suitable as such a third coating layer include TiC, TiN, TiCN, TiCNO, TiB₂, TiBN, TiCBN, ZrC, ZrO₂ HfC, HfN, TiAIN, AlCrN, CrN, VN, TiSiN, TiSiCN, AlTiCrN, TiAlCN, and the like.

The third coating layer has a thickness (the total thickness if the third coating layer is formed by a plurality of layers) of preferably at least 0.01µm to at most 27µm. If the thickness is smaller than 0.01µm, an effect to improve adhesiveness to the substrate and the first coating layer may not sufficiently be exhibited. Meanwhile, if the thickness exceeds 27µm, there is not much difference in the effect, and it is economically disadvantageous.

The third coating layer may be formed directly on the substrate. Any method such as conventionally known chemical vapor deposition (CVD) and physical vapor deposition (PVD) may be adopted as a method of forming the third coating layer (forming method), and the forming method is not particularly limited.

Preferably, the third coating layer is formed, among others, with MT-CVD (medium temperature CVD). Particularly, it is optimal to include a titanium carbonitride (TiCN) layer which is excellent in wear resistance and formed with that method. In the conventional CVD method, the layer is formed at a temperature of approximately 1020 to 1030°C, whereas in the MT-CVD, the layer can be formed at a relatively low temperature of approximately 850 to 950°C. Accordingly, damage to the substrate due to heating in forming the layer can be lowered. Therefore, the layer formed with MT-CVD is preferably provided proximate to the substrate. In addition, nitrile-based gas, particularly acetonitrile (CH₃CN), is preferred as a gas for forming the layer, because of its good productivity.

### <Fourth Coating Layer>

The fourth coating layer according to the present invention is formed on the second coating layer, in a portion excluding at least an area involved with cutting as desired. The fourth coating layer attains a function as an indicating layer that facilitates recognition of the used state of the tool. In addition, the fourth coating layer may also attain a function as an index layer that indicates whether or not blasting treatment for providing compressive stress to the second coating layer or for improving surface smoothness of the tool has been performed.

Therefore, preferably, the fourth coating layer has wear resistance poorer than the second coating layer above, and suitably it has a color such as yellow, gold, silver, or pink.

It is noted that the area involved with cutting herein refers to the area identical to that described in connection with the second coating layer discussed above. The reason why the fourth coating layer is formed in the portion excluding the area involved with cutting is to prevent appearance of the work material from being impaired due to reaction of the coating layer with the work material and adhesion of the resultant substance to the cutting edge of the tool.

Preferably, the fourth coating layer is composed, for example, of at least one metal selected from the group consisting of the IVa-group elements, the Va-group elements and the VIa-group elements in the periodic table, Al, Si, Cu, Pt, Au, Ag, Pd, Fe, Co, and Ni, or a compound of at least one element selected from the group consisting of the IVa-group elements, the Va-group elements and the VIa-group elements in the periodic table, Al, and Si and at least one element selected from the group consisting of carbon, nitrogen, oxygen, and boron. More specifically, the fourth coating layer may be formed from an element or a compound such as TiN, ZrN, TiCN, TiSiCN, TiCNO, VN, Cr, and the like.

The fourth coating layer preferably has a thickness of at least 0.01µm to at most 5µm. If the thickness is smaller than 0.01µm, the function as above may not sufficiently be exhibited. Meanwhile, if the thickness exceeds 5µm, efficiency in manufacturing is lowered, which is economically disadvantageous.

The fourth coating layer may be formed directly on the second coating layer. Any method such as conventionally known chemical vapor deposition (CVD) and physical vapor deposition (PVD) may be adopted as a method of forming the fourth coating layer (forming method), and the forming method is not particularly limited. Particularly preferably as the forming method, however, CVD or PVD is suitably used to form the fourth coating layer so as to cover the entire surface of the second coating layer, and thereafter the fourth coating layer formed at least in the area involved with cutting is removed through blasting treatment or the like. This method has an effect to provide compressive stress to the second coating layer simultaneously with the surface smoothening treatment, thus attaining high productivity.

### <Example>

In the following, the present invention will be described in detail with reference to examples, however, the present invention is not limited thereto.

### <Example 1>

Initially, the following three types of substrates A to C were fabricated as the substrate.

Substrate A was fabricated as follows. Raw material powders having a composition of 86.7 mass % WC, 3.0 mass % TaC, 0.3 mass % NbC, 2.2 mass % TiC, and 7.8 mass % Co were pressed, and thereafter sintered for one hour at a temperature of 1400°C in a vacuum atmosphere. Then, the resultant sintered object was subjected to grinding treatment and thereafter the cutting-edge portion was subjected to cutting-edge treatment using SiC brush honing treatment (curve (R) of a radius of approximately 0.05mm was provided to the intersection of the rake face and the flank face), thus fabricating a cutting insert made of cemented carbide in a shape the same as that of cutting insert CNMG120408N-GU (manufactured by Sumitomo Electric Hardmetal Corp.).

Substrate B was fabricated in a manner similar to substrate A, except for using raw material powder composition of 84.2 mass % WC, 1.0 mass % TaC, 3.5 mass % NbC, 3.0 mass % ZrC, 0.5 mass % ZrN, and 7.8 mass % Co.

Substrate C was fabricated in a manner similar to substrate A, except for using raw material powder composition of 93.4 mass % WC, 0.6 mass % TaC, 0.3 mass % NbC, 0.2 mass % TiC, and 5.5 mass % Co.

Substrate A had the beta (β) removal layer formed on its surface to a thickness of 10µm, and substrate B also had the beta (β) removal layer formed on its surface to a thickness of 15µm. The beta (β) removal layer was not formed in substrate C.

Thereafter, coating layers shown in Tables 1 and 2 below were formed with conventionally known CVD on these substrates, except that titanium carbonitride (TiCN) in the third coating layer was formed with MT-CVD at a temperature of 850 to 900°C.

The first coating layer is composed of titanium boronitride expressed as TiB_{X}N_{Y}, and when X/(X+Y) satisfies the relation of 0.001<X/(X+Y)<0.04, a reaction gas composed of 2 volume % TiCl₄, 0.005 to 2 volume % BCl₃, 5 to 15 volume % N₂, 5 to 15 volume % NO, and H₂ for the rest was used to form the layer under a condition of a pressure set to 4 to 10.7kPa and a temperature set to 800 to 930°C. On the other hand, if X/(X+Y) does not satisfy the relation of 0.001<X/(X+Y)<0.04, a reaction gas composed of 2 volume % TiCl₄, at most 0.001 volume % or 5 volume % BCl₃, 5 to 15 volume % N₂, 1 to 10 volume % NO, and H₂ for the rest was used to form the layer under a condition of a pressure set to 13.3kPa and a temperature set to 950°C.

As the tensile stress remains in the second coating layer, the coating layer formed as above was subjected to known blasting treatment so as to provide compressive stress on the entire surface (note that Nos. 25 and 26 in Table 2 below were not subjected to blasting treatment). The stress provided in this manner was measured with the sin²ψ method (as described above, stress was calculated as the average of the stress at any 10 points included in the area involved with cutting), and the coating layer had residual stress (compressive stress) as shown in Tables 1 and 2.

Surface-coated cutting tools Nos. 1 to 26 in Tables 1 and 2 were thus fabricated. Nos. 1 to 22 represent the examples of the present invention, and Nos. 23 to 26 represent comparative examples.

Then, these surface-coated cutting tools were subjected to a wear resistance test and an interrupted cutting test under the conditions below. Tables 1 and 2 below show the result. A flank face wear amount (V_{B}) was measured in the wear resistance test, and a smaller flank face wear amount indicates better wear resistance. Meanwhile, the number of times of impacts until the tool is chipped was counted in the interrupted cutting test, and a greater number indicates better toughness.
(Wear resistance test)
Work material: SCM435 round rod
Cutting speed: 250m/min
Depth of cut d: 2.0mm
Feed f: 0.30mm/rev.
Cutting time period: 12 minutes
Dry/Wet: Wet
(Interrupted cutting test)
Work material: SCM440 (round rod with 4 grooves)
Cutting speed: 180m/min
Depth of cut: 1.5mm
Feed: 0.35mm/rev.
Dry/Wet: Wet

**Table 1**

| | No. | Substrate | Coating Layer numeric value in parentheses indicating thickness (µm) | | | | | | X/(X+Y) | Residual Stress GPa | Wear-Resistance Test (mm) | Interrupted Cutting Test (Times) |
|---|---|---|---|---|---|---|---|---|---|---|---|---|
| | | | Third Coating Layer | | | First Coating Layer | Second coating Layer | Fourth Coating Layer | | | | |
| | 1 | A | TiN(0.9) | TiCN(3.0) | - | TiBN(1.0) | α-Al₂O₃(2.5) | - | 0.011 | -0.6 | 0.088 | 7214 |
| | 2 | B | TiN(1.1) | TiCN(3.2) | - | TiBN(0.9) | α-Al₂O₃(2.4) | - | 0.010 | -0.7 | 0.066 | 7121 |
| | 3 | C | TiN(1.0) | TiCN(2.8) | - | TiBN(1.2) | α-Al₂O₃(2.6) | - | 0.012 | -0.6 | 0.046 | 6458 |
| | 4 | A | TiN(1.1) | TiCN(3.1) | - | TiBN(1.0) | κ-Al₂O₃(2.2) | - | 0.011 | -0.8 | 0.096 | 7347 |
| | 5 | A | TiN(1.0) | TiCN(3.0) | - | TiBN(0.7) | α-Al₂O₃(2.5) | - | 0.037 | -0.7 | 0.084 | 7152 |
| | 6 | A | TiN(0.8) | TiCN(3.2) | - | TiBN(1.0) | α-Al₂O₃(2.5) | - | 0.002 | -0.7 | 0.089 | 7116 |
| | 7 | A | TiN(1.0) | TiCN(3.2) | - | TiBN(1.0) | α-Al₂O₃(2.5) | - | 0.031 | -1.3 | 0.090 | 8658 |
| | 8 | A | TiN(0.7) | TiCN(2.9) | - | TiBN(1.0) | α-Al₂O₃(2.5) | - | 0.030 | -2.6 | 0.091 | 10122 |
| | 9 | A | TiN(1.0) | TiCN(3.1) | - | TiBN(0.2) | α-Al₂O₃(5.4) | - | 0.014 | -0.6 | 0.041 | 6124 |
| | 10 | A | TiN(1.0) | TiCN(2.0) | - | TiBN(2.8) | α-Al₂O₃(2.6) | - | 0.015 | -0.7 | 0.090 | 6980 |
| | 11 | A | TiN(1.0) | TiCN(2.0) | - | TiBN(2.8) | α-Al₂O₃(2.6) | - | 0.011 | -0.1 | 0.092 | 5788 |
| | 12 | A | TiN(1.1) | TiCN(5.5) | TiC(2.0) | TiBN(1.0) | κ-Al₂O₃(2.2) | - | 0.011 | -0.6 | 0.094 | 7782 |
| | 13 | A | - | TiCN(6.8) | - | TiBN(0.8) | α-Al₂O₃(3.1) | - | 0.011 | -0.8 | 0.068 | 5980 |

**Table 2**

| | No. | Substrate | Coating Layer numeric value in parentheses indicating thickness (µm) | | | | | | X/(X+Y) | Residual Stress GPa | Wear-Resistance Test (mm) | Interrupted Cutting Test (Times) |
|---|---|---|---|---|---|---|---|---|---|---|---|---|
| | | | Third Coating Layer Third Coating Layer | | | First Coating Layer | Second Coating Layer | Fourth Coating Layer | | | | |
| | 14 | A | TiN(1.0) | TiCN(3.1) | - | TiBN(1.1) | ZrO₂(1.6) | - | 0.012 | -0.7 | 0.049 | 6887 |
| | 15 | A | TiN(1.0) | TiCN(3.2) | - | TiBN(0.8) | HfO₂(1.9) | - | 0.010 | -0.8 | 0.054 | 6780 |
| | 16 | A | TiN(1.1) | TiCN(9.4) | - | TiBN(0.9) | α-Al₂O₃(3.1) | - | 0.013 | -0.8 | 0.047 | 7011 |
| | 17 | A | TiN(1.1) | TiCN(11.8) | - | TiBN(0.9) | α-Al₂O₃(6.1) | - | 0.013 | -0.6 | 0.041 | 6024 |
| | 18 | A | TiN(1.0) | TiCN(3.0) | - | TiBN(1.0) | α-Al₂O₃(2.5) | TiN(0.9) | 0.012 | -0.7 | 0.089 | 7144 |
| | 19 | A | - | - | - | TiBN(0.1) | κ-Al₂O₃(0.2) | - | 0.012 | -0.4 | 0.101 | 9781 |
| | 20 | A | TiN(0.9) | TiCN(3.1) | - | TiBN(0.9) | α-Al₂O₃(2.4) | - | 0.0001 | -0.6 | 0.112 | 9912 |
| | 21 | A | TiN(1.1) | TiCN(3.0) | - | TiBN(1.0) | α-Al₂O₃(2.6) | - | 0.05 | -0.7 | 0.114 | 6219 |
| | 22 | A | TiN(0.8) | TiCN(5.2) | - | TiBN(0.7) | Solid Solution (3.0) | - | 0.016 | -0.5 | 0.048 | 6885 |
| * | 23 | A | TiN(1.0) | TiCN(3.2) | TiN(1.0) | - | α-Al₂O₃(2.5) | - | - | -0.6 | 0.168 | 6223 |
| * | 24 | A | - | TiCN(6.8) | - | - | α-Al₂O₃(3.1) | - | - | -0.7 | 0.189 | 6899 |
| * | 25 | A | TiN(1.1) | TiCN(3.1) | - | TiBN(1.0) | κ-Al₂O₃(2.2) | - | 0.012 | +0.5 | 0.071 | 702 |
| * | 26 | A | TiN(1.1) | TiCN(3.1) | - | TiBN(1.0) | α-Al₂O₃(2.2) | - | 0.01 | +0.3 | 0.082 | 513 |

In Tables 1 and 2, the tool marked with "asterisk" represents comparative example. As to the second coating layer, "α-Al₂O₃" represents α-aluminum oxide, and "κ-Al₂O₃" represents κ-aluminum oxide. The second coating layer of No. 22 represents a solid solution having a mass ratio between aluminum oxide and zirconium oxide of 9:1. In addition, "X/(X+Y)" represents X/(X+Y) in the formula of TiB_{X}N_{Y} composing the first coating layer, and the "residual stress" represents the stress of the second coating layer measured with the measurement method above.

When a plurality of components are shown as the third coating layer in Tables 1 and 2, this indicates that these components were formed on the substrate successively from the one in the left in the table. The fourth coating layer of No. 18 was formed in a portion except for the area involved with cutting, as a result of removal with blasting treatment. Unless the fourth coating layer is removed in this manner (if the fourth coating layer is formed in the area involved with cutting), wear resistance, particularly toughness, is poor, and appearance of the work material is also impaired.

As can clearly be seen from Tables 1 and 2 above, all the surface-coated cutting tools Nos. 1 to 22 according to the present invention had excellent wear resistance and toughness (there was no tool in which the second coating layer peeled off). In contrast, the surface-coated cutting tools Nos. 23 and 24 not having the first coating layer were poor in wear resistance, and a tendency of peeling of the second coating layer was shown. In addition, Nos. 25 and 26 having the tensile residual stress in the second coating layer had extremely poor toughness.

Moreover, the surface-coated cutting tools Nos. 1 to 22 according to the present invention gave yellowish appearance as a whole, and the used state of the tool (which cutting-edge portion has already been used) could readily be recognized.

Though the substrate having a chip breaker was used in the present example, the substrate not having the chip breaker or the tool (insert) having its upper and lower surfaces polished can achieve an effect the same as in the present example.

### <Example 2>

Raw material powders having a composition of 88.7 mass % WC, 2.0 mass % TaC, 0.8 mass % NbC, and 8.5 mass % Co were pressed, and thereafter sintered for one hour at a temperature of 1400°C in a vacuum atmosphere. Then, the resultant sintered object was subjected to grinding treatment and thereafter the cutting-edge portion was subjected to cutting-edge treatment using SiC brush honing treatment (curve (R) of a radius of approximately 0.04mm was provided to the intersection of the rake face and the flank face), thus fabricating a cutting insert made of cemented carbide in a shape of ISO standard SPGN120412. This cutting insert was employed as the substrate. The beta (β) removal layer was not present in this substrate.

Thereafter, coating layers shown in Table 3 below were formed with conventionally known CVD on this substrate, except that titanium carbonitride (TiCN) in the third coating layer was formed with MT-CVD at a temperature of 850 to 900°C. The first coating layer was formed using the same condition as in Example 1.

As the tensile stress remains in the second coating layer, the coating layer formed as above was subjected to known blasting treatment so as to provide compressive stress on the entire surface (note that No. 39 in Table 3 below was not subjected to blasting treatment). The stress provided in this manner was measured with the sin²ψ method as in Example 1, and the coating layer had residual stress (compressive stress) as shown in Table 3.

Surface-coated cutting tools Nos. 31 to 39 in Table 3 were thus fabricated. Nos. 31 to 36 represent the examples of the present invention, and Nos. 37 to 39 represent comparative examples.

Then, these surface-coated cutting tools were subjected to three types of milling-cutting test under the conditions below. Table 3 below shows the result. A flank face wear amount (V_{B}) was measured in a wear resistance test for steel and in a wear resistance test for casting, and a smaller flank face wear amount indicates better wear resistance. Meanwhile, in the toughness cutting test, cutting was performed using 10 different cutting edges, and the number of broken cutting edges was counted. A smaller count of broken cutting edges indicates better toughness.
(Wear resistance test for steel)
Work material: SCM435 block material
Cutting speed: 310m/min
Depth of cut d: 2.0mm
Feed f: 0.28mm/rev.
Cutting time period: 10 minutes
Dry/Wet: Wet
(Wear resistance test for casting)
Work material: FC250 block material
Cutting speed: 250m/min
Depth of cut d: 1.5mm
Feed f: 0.29mm/rev.
Cutting time period: 12 minutes
Dry/Wet: Dry
(Toughness cutting test)
Work material: SCM435 block material (with slit)
Cutting speed: 160m/min
Depth of cut: 2.0mm
Feed: 0.37mm/rev.
Dry/Wet: Wet
Cutter: DPG4100R (manufactured by Sumitomo Electric Hardmetal Corp.)

As one surface-coated cutting tool (cutting insert) was attached to the cutter, feed per one turn of the cutter is equal to the feed per one tooth.

**Table 3**

| | No. | Coating Layer numeric value in parentheses indicating thickness (µm) | | | | | | X/(X+Y) | Residual Stress GPa | Wear Resistance Test for Steel (mm) | Wear Resistance Test for Casting (mm) | Toughness Cutting Test (Count) |
|---|---|---|---|---|---|---|---|---|---|---|---|---|
| | | Third Coating Layer | | | First Coating Layer | Coating Layer | Fourth Coating Layer | | | | | |
| | 31 | TiN(0.8) | TiCN(3.0) | - | TiBN(0.4) | α-Al₂O₃(2.1) | - | 0.011 | -0.5 | 0.102 | 0.112 | 1 |
| | 32 | TiN(0.8) | TiCN(3.1) | - | TiBN(0.4) | κ-Al₂O₃(2.2) | - | 0.011 | -2.3 | 0.114 | 0.123 | 0 |
| | 33 | TiN(0.7) | TiCN(2.9) | - | TiBN(1.0) | α-Al₂O₃(2.5) | - | 0.018 | -3.0 | 0.113 | 0.119 | 0 |
| | 34 | - | TiCN(6.8) | - | TiBN(0.8) | α-Al₂O₃(3.1) | - | 0.011 | -0.7 | 0.098 | 0.101 | 1 |
| | 35 | TiN(0.7) | TiCN(2.4) | - | TiBN(0.4) | κ-Al₂O₃(2.1) | TiN(0.5) | 0.012 | -0.6 | 0.112 | 0.117 | 1 |
| | 36 | - | - | - | TiBN(0.7) | κ-Al₂O₃(2.5) | - | 0.012 | -0.5 | 0.124 | 0.119 | 1 |
| * | 37 | TiN(0.8) | TiCN(3.0) | TiN(0.4) | - | α-Al₂O₃(2.1) | - | - | -0.6 | 0.198 | 0.213 | 6 |
| * | 38 | TiN(0.8) | TiCN(3.1) | TiN(0.4) | - | κ-Al₂O₃(2.2) | - | - | -2.1 | 0.188 | 0.201 | 6 |
| * | 39 | TiN(0.8) | TiCN(3.1) | - | TiBN(0.4) | κ-Al₂O₃(2.2) | - | 0.012 | +0.4 | 0.121 | 0.131 | 10 |

Denotation in Table 3 is in line with denotation in Tables 1 and 2. The fourth coating layer of No. 35 was formed in a portion except for the area involved with cutting, as a result of removal with blasting treatment. Unless the fourth coating layer is removed in this manner (if the fourth coating layer is formed in the area involved with cutting), wear resistance, particularly toughness, is poor, and appearance of the work material is also impaired.

As can clearly be seen from Table 3 above, all the surface-coated cutting tools Nos. 31 to 36 according to the present invention had excellent wear resistance and toughness (there was no tool in which the second coating layer peeled off). In contrast, the surface-coated cutting tools Nos. 37 and 38 not having the first coating layer were poor in wear resistance and toughness, and a tendency of peeling of the second coating layer was shown. In addition, No. 39 having the tensile residual stress in the second coating layer had extremely poor toughness.

Moreover, the surface-coated cutting tools Nos. 31 to 36 according to the present invention gave yellowish appearance as a whole, and the used state of the tool (which cutting-edge portion has already been used) could readily be recognized.

### <Example 3>

The substrate the same as in Example 2 was used, and the coating layers shown in Table 4 below were formed on the substrate with conventionally known ion plating, thus fabricating the surface-coated cutting tool. Unlike Examples 1 and 2, the second coating layer was given compressive stress at the time of forming thereof (compressive stress was measured in a manner similar to that in Examples 1 and 2, and the result is shown in Table 4). Therefore, blasting treatment was not performed.

Surface-coated cutting tools Nos. 41 to 47 in Table 4 were thus fabricated. Nos. 41 to 44 represent the examples of the present invention, and Nos. 45 to 47 represent comparative examples.

Then, these surface-coated cutting tools were subjected to three types of milling-cutting test under the conditions below. Table 4 below shows the result. A flank face wear amount (V_{B}) was measured in the wear resistance test for steel and in the wear resistance test for casting, and a smaller flank face wear amount indicates better wear resistance. Meanwhile, in the toughness cutting test, cutting was performed using 10 different cutting edges, and the number of broken cutting edges was counted. A smaller count of broken cutting edges indicates better toughness.
(Wear resistance test for steel)
Work material: SKD11 block material
Cutting speed: 160m/min
Depth of cut d: 2.0mm
Feed f: 0.26mm/rev.
Cutting time period: 5 minutes
Dry/ Wet: Wet
(Wear resistance test for casting)
Work material: FCD450 block material
Cutting speed: 180m/min
Depth of cut d: 1.5mm
Feed f: 0.27mm/rev.
Cutting time period: 6 minutes
Dry/Wet: Dry
(Toughness cutting test)
Work material: S50C block material (with slit)
Cutting speed: 150m/min
Depth of cut: 2.0mm
Feed: 0.38mm/rev.
Dry/Wet: Wet
Cutter: DPG4100R (manufactured by Sumitomo Electric Hardmetal Corp.)

As one surface-coated cutting tool (cutting insert) was attached to the cutter, feed per one turn of the cutter is equal to the feed per one tooth.

**Table 4**

| | No. | Coating Layer numeric value in parentheses indicating thickness (µm) | | | | | X/(X+Y) | Residual Stress GPa | Wear Resistance Test for Steel (mm) | Wear Resistance Test for Casting (mm) | Toughness Cutting Test (Count) |
|---|---|---|---|---|---|---|---|---|---|---|---|
| | | Third Coating Layer | | | First Coating Layer | Second Coating Layer | | | | | |
| | 41 | TiN(0.2) | TiAlN(2.2) | - | TiBN(0.3) | α-Al₂O₃(2.1) | 0.013 | -2.5 | 0.115 | 0.087 | 0 |
| | 42 | TiN(0.2) | AlCrN(2.1) | - | TiBN(0.4) | κ-Al₂O₃(2.2) | 0.015 | -2.3 | 0.121 | 0.091 | 0 |
| | 43 | - | TiAlN(0.7) | - | TiBN(1.0) | α-Al₂O₃(2.5) | 0.011 | -3.0 | 0.101 | 0.085 | 0 |
| | 44 | - | - | - | TiBN(0.4) | κ-Al₂O₃(1.7) | 0.012 | -1.9 | 0.124 | 0.101 | 0 |
| * | 45 | TiN(0.2) | TiAlN(2.2) | TiN(0.3) | - | α-Al₂O₃(2.1) | - | -2.4 | 0.213 | 0.224 | 4 |
| * | 46 | TiN(0.2) | AlCrN(2.1) | - | - | κ-Al₂O₃(2.2) | - | -2.7 | 0.186 | 0.199 | 5 |
| * | 47 | - | TiAlN(0.7) | CrN(1.0) | - | α-Al₂O₃(2.5) | - | -2.8 | 0.192 | 0.213 | 5 |

Denotation in Table 4 is in line with denotation in Tables 1 to 3. As can clearly be seen from Table 4 above, all the surface-coated cutting tools Nos. 41 to 44 according to the present invention had excellent wear resistance and toughness (there was no tool in which the second coating layer peeled off). In contrast, the surface-coated cutting tools Nos. 45 to 47 not having the first coating layer were poor in wear resistance and toughness, and a tendency of peeling of the second coating layer was shown.

Moreover, the surface-coated cutting tools Nos. 41 to 44 according to the present invention gave yellowish appearance as a whole, and the used state of the tool (which cutting-edge portion has already been used) could readily be recognized.

### <Example 4>

Initially, the following three types of substrates A2 to C2 were fabricated as the substrate.

Substrate A2 was fabricated as follows. Raw material powders having a composition of 86.7 mass % WC, 3.0 mass % TaC, 0.3 mass % NbC, 2.2 mass % TiC, and 7.8 mass % Co were pressed, and thereafter sintered for one hour at a temperature of 1400°C in a vacuum atmosphere. Then, the resultant sintered object was subjected to grinding treatment and thereafter the cutting-edge portion was subjected to cutting-edge treatment using SiC brush honing treatment (curve (R) of a radius of approximately 0.05mm was provided to the intersection of the rake face and the flank face), thus fabricating a cutting insert made of cemented carbide in a shape the same as that of cutting insert CNMG120408N-GU (manufactured by Sumitomo Electric Hardmetal Corp.).

Substrate B2 was fabricated in a manner similar to substrate A2, except for using raw material powder composition of 84.2 mass % WC, 1.0 mass % TaC, 3.5 mass % NbC, 3.0 mass % ZrC, 0.5 mass % ZrN, and 7.8 mass % Co.

Substrate C2 was fabricated in a manner similar to substrate A2, except for using raw material powder composition of 93.4 mass % WC, 0.6 mass % TaC, 0.3 mass % NbC, 0.2 mass % TiC, and 5.5 mass % Co.

Substrate A2 had the beta (β) removal layer formed on its surface to a thickness of 10µm, and substrate B2 also had the beta (β) removal layer formed on its surface to a thickness of 15µm. The beta (β) removal layer was not formed in substrate C2.

Thereafter, coating layers shown in Tables 5 and 6 below were formed with conventionally known CVD on these substrates, except that titanium carbonitride (TiCN) in the third coating layer was formed with MT-CVD at a temperature of 850 to 900°C.

The first coating layer is composed of titanium boron-oxynitride expressed as TiB_{X}N_{Y}O_{Z}, and when X/(X+Y+Z) satisfies the relation of 0.0005<X/(X+Y+Z)<0.04 and Z/(X+Y+Z) satisfies the relation of 0<Z/(X+Y+Z)<0.5, a reaction gas composed of 2 volume % TiCl₄, 0.005 to 2 volume % BCl₃, 5 to 15 volume % N₂, 5 to 15 volume % NO, and H₂ for the rest was used to form the layer under a condition of a pressure set to 4 to 10.7kPa and a temperature set to 800 to 930°C. On the other hand, if X/(X+Y+Z) does not satisfy the relation of 0.0005<X/(X+Y+Z)<0.04 and Z/(X+Y+Z) does not satisfy the relation of 0<Z/(X+Y+Z)<0.5, a reaction gas composed of 2 volume % TiCl₄, at most 0.001 volume % or 5 volume % BCl₃, 5 to 15 volume % N₂, 1 to 10 volume % NO, and H₂ for the rest was used to form the layer under a condition of a pressure set to 13.3kPa and a temperature set to 950°C.

As the tensile stress remains in the second coating layer, the coating layer formed as above was subjected to known blasting treatment so as to provide compressive stress on the entire surface (note that Nos. 125 and 126 in Table 6 below were not subjected to blasting treatment). The stress provided in this manner was measured with the sin²ψ method (as described above, stress was calculated as the average of the stress at any 10 points included in the area involved with cutting), and the coating layer had residual stress (compressive stress) as shown in Tables 5 and 6.

Surface-coated cutting tools Nos. 101 to 126 in Tables 5 and 6 were thus fabricated. Nos. 101 to 122 represent the examples of the present invention, and Nos. 123 to 126 represent comparative examples.

Then, these surface-coated cutting tools were subjected to a wear resistance test and an interrupted cutting test under the conditions below. Tables 5 and 6 below show the result. A flank face wear amount (V_{B}) was measured in the wear resistance test, and a smaller flank face wear amount indicates better wear resistance. The number of times of impacts until the tool is chipped was counted in the interrupted cutting test, and a greater number indicates better toughness.
(Wear resistance test)
Work material: SCM435 round rod
Cutting speed: 240m/min
Depth of cut d: 2.0mm
Feed f: 0.31mm/rev.
Cutting time period: 12 minutes
Dry/Wet: Wet
(Interrupted cutting test)
Work material: SCM440 (round rod with 4 grooves)
Cutting speed: 170m/min
Depth of cut: 1.5mm
Feed: 0.36mm/rev.
Dry/Wet: Wet

**Table 5**

| | No. | Substrate | Coating Layer numeric value in parentheses indicating thickness (µm) | | | | | | X | Z | Residual Stress GPa | Wear-Resistance Test (mm) | Interrupted Cutting Test (Times) |
|---|---|---|---|---|---|---|---|---|---|---|---|---|---|
| | | | Third Coating Layer | | | First Coating Layer | Second Coating Layer | Fourth Coating Layer | | | | | |
| | 101 | A2 | TiN(0.9) | TiCN(3.0) | - | TiBNO(1.0) | α-Al₂O₃(2.5) | - | 0.012 | 0.23 | -0.5 | 0.089 | 7143 |
| | 102 | B2 | TiN(1.1) | TiCN(3.2) | - | TiBNO(0.9) | α-Al₂O₃(2.4) | - | 0.011 | 0.23 | -0.6 | 0.071 | 7327 |
| | 103 | C2 | TiN(1.0) | TiCN(2.8) | - | TiBNO(1.2) | α-Al₂O₃(2.6) | - | 0.014 | 0.24 | -0.7 | 0.048 | 6489 |
| | 104 | A2 | TiN(1.1) | TiCN(3.1) | - | TiBNO(1.0) | κ-Al₂O₃(2.2) | - | 0.013 | 0.22 | -0.7 | 0.091 | 7249 |
| | 105 | A2 | TiN(1.0) | TiCN(3.0) | - | TiBNO(0.7) | α-Al₂O₃(2.5) | - | 0.038 | 0.011 | -0.8 | 0.088 | 7327 |
| | 106 | A2 | TiN(0.8) | TiCN(3.2) | - | TiBNO(1.0) | α-Al₂O₃(2.5) | - | 0.001 | 0.26 | -0.7 | 0.081 | 7268 |
| | 107 | A2 | TiN(1.0) | TiCN(3.2) | - | TiBNO(1.0) | α-Al₂O₃(2.5) | - | 0.034 | 0.05 | -1.4 | 0.095 | 8556 |
| | 108 | A2 | TiN(0.7) | TiCN(2.9) | - | TiBNO(1.0) | α-Al₂O₃(2.5) | - | 0.029 | 0.09 | -2.5 | 0.088 | 10149 |
| | 109 | A2 | TiN(1.0) | TiCN(3.1) | - | TiBNO(0.2) | α-Al₂O₃(5.4) | - | 0.012 | 0.24 | -0.7 | 0.043 | 6188 |
| | 110 | A2 | TiN(1.0) | TiCN(2.0) | - | TiBNO(2.8) | α-Al₂O₃(2.6) | - | 0.011 | 0.23 | -0.6 | 0.101 | 6921 |
| | 111 | A2 | TiN(1.0) | TiCN(2.0) | - | TiBNO(2.8) | α-Al₂O₃(2.6) | - | 0.014 | 0.24 | -0.1 | 0.098 | 5791 |
| | 112 | A2 | TiN(1.1) | TiCN(5.5) | TiC(2.0) | TiBNO(1.0) | κ-Al₂O₃(2.2) | - | 0.013 | 0.23 | -0.7 | 0.087 | 7771 |
| | 113 | A2 | - | TiCN(6.8) | - | TiBNO(0.8) | α-Al₂O₃(3.1) | - | 0.012 | 0.25 | -0.8 | 0.071 | 5983 |

**Table 6**

| | No. | Substrate | Coating Layer numeric value in parentheses indicating thickness (µm) | | | | | | X | Z | Residual Stress GPa | Wear-Resistance Test (mm) | Interrupted Cutting Test (Times) |
|---|---|---|---|---|---|---|---|---|---|---|---|---|---|
| | | | Third Coating Layer | | | First Coating Layer | Second Coating Layer | Fourth Coating Layer | | | | | |
| | 114 | A2 | TiN(1.0) | TiCN(3.1) | - | TiBNO(1.1) | ZrO₂(1.6) | - | 0.015 | 0.21 | -0.6 | 0.048 | 6899 |
| | 115 | A2 | TiN(1.0) | TiCN(3.2) | - | TiBNO(0.8) | HfO₂(1.9) | - | 0.011 | 0.23 | -0.7 | 0.053 | 6721 |
| | 116 | A2 | TiN(1.1) | TiCN(9.4) | - | TiBNO(0.9) | α-Al₂O₃(3.1) | - | 0.012 | 0.24 | -0.7 | 0.048 | 7084 |
| | 117 | A2 | TiN(1.1) | TiCN(11.8) | - | TiBNO(0.9) | α-Al₂O₃(6.1) | - | 0.013 | 0.24 | -0.6 | 0.043 | 6046 |
| | 118 | A2 | TiN(1.0) | TiCN(3.0) | - | TiBNO(1.0) | α-Al₂O₃(2.5) | TiN(0.9) | 0.011 | 0.27 | -0.8 | 0.091 | 7159 |
| | 119 | A2 | - | - | - | TiBNO(0.1) | κ-Al₂O₃(0.2) | - | 0.013 | 0.20 | -0.4 | 0.106 | 9271 |
| | 120 | A2 | TiN(0.9) | TiCN(3.1) | - | TiBNO(0.9) | α-Al₂O₃(2.4) | - | 0.0002 | 0.45 | -0.7 | 0.121 | 9018 |
| | 121 1 | A2 | TiN(1.1) | TiCN(3.0) | - | TiBNO(1.0) | α-Al₂O₃(2.6) | - | 0.04 | 0.0002 | -0.6 | 0.119 | 6350 |
| | 122 | A2 | TiN(0.8) | TiCN(5.2) | - | TiBNO(0.7) | Solid Solution Solid Solution (3.0) | - | 0.016 | 0.22 | -0.7 | 0.044 | 6919 |
| * | 123 | A2 | TiN(1.0) | TiCN(3.2) | TiN(1.0) | - | α-Al₂O₃(2.5) | - | - | - | -0.7 | 0.171 | 5911 |
| * | 124 | A2 | - | TiCN(6.8) | - | - | α-Al₂O₃(3.1) | - | - | - | -0.6 | 0.188 | 5639 |
| * | 125 | A2 | TiN(1.1) | TiCN(3.1) | - | TiBNO(1.0) | κ-Al₂O₃(2.2) | - | 0.011 | 0.23 | +0.6 | 0.076 | 598 |
| * | 126 | A2 | TiN(1.1) | TiCN(3.1) | - | TiBNO(1.0) | α-Al₂O₃(2.2) | - | 0.011 | 0.25 | +0.3 | 0.081 | 495 |

In Tables 5 and 6, the tool marked with "asterisk" represents comparative example. As to the second coating layer, "α-Al₂O₃" represents α-aluminum oxide, and "κ-Al₂O₃" represents κ-aluminum oxide. The second coating layer of No. 122 represents a solid solution having a mass ratio between aluminum oxide and zirconium oxide of 9:1. In addition, "X" represents X/(X+Y+Z) in the formula of TiB_{X}N_{Y}O_{Z} composing the first coating layer, "Z" represents Z/(X+Y+Z) in the formula of TiB_{X}N_{Y}O_{Z} composing the first coating layer, and the "residual stress" represents the stress of the second coating layer measured with the measurement method above.

When a plurality of components are shown as the third coating layer in Tables 5 and 6, this indicates that the components are formed on the substrate successively from the one in the left in the table. The fourth coating layer of No. 118 was formed in a portion except for the area involved with cutting, as a result of removal with blasting treatment. Unless the fourth coating layer is removed in this manner (if the fourth coating layer is formed in the area involved with cutting), wear resistance, particularly toughness, is poor, and appearance of the work material is also impaired.

As can clearly be seen from Tables 5 and 6 above, all the surface-coated cutting tools Nos. 101 to 122 according to the present invention had excellent wear resistance and toughness (there was no tool in which the second coating layer peeled off). In contrast, the surface-coated cutting tools Nos. 123 and 124 not having the first coating layer were poor in wear resistance, and a tendency of peeling of the second coating layer was shown. In addition, Nos. 125 and 126 having the tensile residual stress in the second coating layer had extremely poor toughness.

Moreover, the surface-coated cutting tools Nos. 101 to 122 according to the present invention gave yellowish appearance as a whole, and the used state of the tool (which cutting-edge portion has already been used) could readily be recognized.

Though the substrate having a chip breaker was used in the present example, the substrate not having the chip breaker or the tool (insert) having its upper and lower surfaces polished can achieve an effect the same as in the present example.

### <Example 5>

Raw material powders having a composition of 88.7 mass % WC, 2.0 mass % TaC, 0.8 mass % NbC, and 8.5 mass % Co were pressed, and thereafter sintered for one hour at a temperature of 1400°C in a vacuum atmosphere. Then, the resultant sintered object was subjected to grinding treatment and thereafter the cutting-edge portion was subjected to cutting-edge treatment using SiC brush honing treatment (curve (R) of a radius of approximately 0.04mm was provided to the intersection of the rake face and the flank face), thus fabricating a cutting insert made of cemented carbide in a shape of ISO standard SPGN120412. This cutting insert was employed as the substrate. The beta (β) removal layer was not present in this substrate.

Thereafter, coating layers shown in Table 7 below were formed with conventionally known CVD on these substrates, except that titanium carbonitride (TiCN) in the third coating layer was formed with MT-CVD at a temperature of 850 to 900°C. The first coating layer was formed using the same condition as in Example 4.

As the tensile stress remains in the second coating layer, the coating layer formed as above was subjected to known blasting treatment so as to provide compressive stress on the entire surface (note that No. 139 in Table 7 below was not subjected to blasting treatment). The stress provided in this manner was measured with the sin²ψ method as in Example 4, and the coating layer had residual stress (compressive stress) as shown in Table 7.

Surface-coated cutting tools Nos. 131 to 139 in Table 7 were thus fabricated. Nos. 131 to 136 represent the examples of the present invention, and Nos. 137 to 139 represent comparative examples.

Then, these surface-coated cutting tools were subjected to three types of milling-cutting test under the conditions below. Table 7 below shows the result. A flank face wear amount (V_{B}) was measured in a wear resistance test for steel and in a wear resistance test for casting, and a smaller flank face wear amount indicates better wear resistance. Meanwhile, in the toughness cutting test, cutting was performed using 10 different cutting edges, and the number of broken cutting edges was counted. A smaller count of broken cutting edges indicates better toughness.
(Wear resistance test for steel)
Work material: SCM435 block material
Cutting speed: 320m/min
Depth of cut d: 2.0mm
Feed f: 0.27mm/rev.
Cutting time period: 10 minutes
Dry/Wet: Wet
(Wear resistance test for casting)
Work material: FC250 block material
Cutting speed: 260m/min
Depth of cut d: 1.5mm
Feed f: 0.28mm/rev.
Cutting time period: 12 minutes
Dry/Wet: Dry
(Toughness cutting test)
Work material: SCM435 block material (with slit)
Cutting speed: 170m/min
Depth of cut: 2.0mm
Feed: 0.36mm/rev.
Dry/Wet: Wet
Cutter: DPG4100R (manufactured by Sumitomo Electric Hardmetal Corp.)

As one surface-coated cutting tool (cutting insert) was attached to the cutter, feed per one turn of the cutter is equal to the feed per one tooth.

**Table 7**

| | No. | Coating Layer numeric value in parentheses indicating thickness (µm) | | | | | | X | Z | Residual Stress GPa | Wear Resistance Test for Steel (mm) | Wear Resistance Test for Casting (mm) | Toughness Cutting Test (Count) |
|---|---|---|---|---|---|---|---|---|---|---|---|---|---|
| | | Third Coating Layer | | | First Coating Layer | Second Coating Layer | Fourth Coating Layer | | | | | | |
| | 131 | TiN(0.8) | TiCN(3.0) | - | TiBNO(0.4) | α-Al₂O₃(2.1) | - | 0.014 | 0.20 | -0.6 | 0.114 | 0.124 | 1 |
| | 132 | TiN(0.8) | TiCN(3.1) | - | TiBNO(0.4) | κ-Al₂O₃(2.2) | - | 0.013 | 0.21 | -2.4 | 0.123 | 0.131 | 0 |
| | 133 | TiN(0.7) | TiCN(2.9) | - | TiBNO(1.0) | α-Al₂O₃(2.5) | - | 0.017 | 0.18 | -3.1 | 0.122 | 0.124 | 0 |
| | 134 | - | TiCN(6.8) | - | TiBNO(0.8) | α-Al₂O₃(3.1) | - | 0.012 | 0.25 | -0.6 | 0.101 | 0.111 | 1 |
| | 135 | TiN(0.7) | TiCN(2.4) | - | TiBNO(0.4) | κ-Al₂O₃(2.1) | TiN(0.5) | 0.015 | 0.19 | -1.0 | 0.122 | 0.116 | 0 |
| | 136 | - | - | - | TiBNO(0.7) | κ-Al₂O₃(2.5) | - | 0.014 | 0.22 | -0.7 | 0.131 | 0.118 | 1 |
| * | 137 | TiN(0.8) | TiCN(3.0) | TiN(0.4) | - | α-Al₂O₃(2.1) | - | - | - | -0.7 | 0.204 | 0.225 | 6 |
| * | 138 | TiN(0.8) | TiCN(3.1) | TiN(0.4) | - | κ-Al₂O₃(2.2) | - | - | - | -2.4 | 0.198 | 0.204 | 6 |
| * | 139 | TiN(O.8) | TiCN(3.1) | - | TiBNO(0.4) | κ-Al₂O₃(2.2) | - | 0.013 | 0.21 | +0.3 | 0.135 | 0.130 | 10 |

Denotation in Table 7 is in line with denotation in Tables 5 and 6. The fourth coating layer of No. 135 was formed in a portion except for the area involved with cutting, as a result of removal with blasting treatment. Unless the fourth coating layer is removed in this manner (if the fourth coating layer is formed in the area involved with cutting), wear resistance, particularly toughness, is poor, and appearance of the work material is also impaired.

As can clearly be seen from Table 7 above, all the surface-coated cutting tools Nos. 131 to 136 according to the present invention had excellent wear resistance and toughness (there was no tool in which the second coating layer peeled off). In contrast, the surface-coated cutting tools Nos. 137 and 138 not having the first coating layer were poor in wear resistance and toughness, and a tendency of peeling of the second coating layer was shown. In addition, No. 139 having the tensile residual stress in the second coating layer had extremely poor toughness.

Moreover, the surface-coated cutting tools Nos. 131 to 136 according to the present invention gave yellowish appearance as a whole, and the used state of the tool (which cutting-edge portion has already been used) could readily be recognized.

### <Example 6>

The substrate the same as in Example 5 was used, and the coating layer shown in Table 8 below was formed on the substrate with conventionally known ion plating, thus fabricating the surface-coated cutting tool. Unlike Examples 4 and 5, the second coating layer was given compressive stress at the time of forming thereof (compressive stress was measured in a manner similar to that in Examples 4 and 5, and the result is shown in Table 8). Therefore, blasting treatment was not performed.

Surface-coated cutting tools Nos. 141 to 147 in Table 8 were thus fabricated. Nos. 141 to 144 represent the examples of the present invention, and Nos. 145 to 147 represent comparative examples.

Then, these surface-coated cutting tools were subjected to three types of milling-cutting test under the conditions below. Table 8 below shows the result. A flank face wear amount (V_{B}) was measured in the wear resistance test for steel and the wear resistance test for casting, and a smaller flank face wear amount indicates better wear resistance. Meanwhile, in the toughness cutting test, cutting was performed using 10 different cutting edges, and the number of broken cutting edges was counted. A smaller count of broken cutting edges indicates better toughness.
(Wear resistance test for steel)
Work material: SKD11 block material
Cutting speed: 170m/min
Depth of cut d: 2.0mm
Feed f: 0.25mm/rev.
Cutting time period: 5 minutes
Dry/Wet: Wet
(Wear resistance test for casting)
Work material: FCD450 block material
Cutting speed: 190m/min
Depth of cut d: 1.5mm
Feed f: 0.26mm/rev.
Cutting time period: 6 minutes
Dry/Wet: Dry
(Toughness cutting test)
Work material: S50C block material (with slit)
Cutting speed: 160m/min
Depth of cut: 2.0mm
Feed: 0.3 9mm/rev.
Dry/Wet: Wet
Cutter: DPG4100R (manufactured by Sumitomo Electric Hardmetal Corp.)

As one surface-coated cutting tool (cutting insert) was attached to the cutter, feed per one turn of the cutter is equal to the feed per one tooth.

**Table 8**

| | No. | Coating Layer numeric value in parentheses indicating thickness (µm) | | | | | X | Z | Residual Stress GPa | Wear Resistance Test for Steel (mm) | Wear Resistance Test for Casting (mm) | Toughness Cutting Test (Count) |
|---|---|---|---|---|---|---|---|---|---|---|---|---|
| | | Third Coating Layer | | | First Coating Layer | Second Coating Layer | | | | | | |
| | 141 | TiN(0.2) | TiAIN(2.2) | - | TiBNO(0.3) | α-Al₂O₃(2.1) | 0.014 | 0.22 | -2.4 | 0.127 | 0.091 | 0 |
| | 142 | TiN(0.2) | AlCrN(2.1) | - | TiBNO(0.4) | κ-Al₂O₃(2.2) | 0.017 | 0.19 | -2.5 | 0.131 | 0.101 | 0 |
| | 143 | - | TiAIN(0.7) | - | TiBNO(1.0) | α-Al₂O₃(2.5) | 0.013 | 0.20 | -3.1 | 0.115 | 0.091 | 0 |
| | 144 | - | - | - | TiBNO(0.4) | κ-Al₂O₃(1.7) | 0.011 | 0.25 | -1.7 | 0.131 | 0.099 | 1 |
| * | 145 | TiN(0.2) | TiAIN(2.2) | TiN(0.3) | - | α-Al₂O₃(2.1) | - | - | -2.5 | 0.232 | 0.231 | 4 |
| * | 146 | TiN(0.2) | AlCrN(2.1) | - | - | κ-Al₂O₃(2.2) | - | - | -2.6 | 0.206 | 0.201 | 5 |
| * | 147 | - | TiAlN(0.7) | CrN(1.0) | - | α-Al₂O₃(2.5) | - | - | -2.7 | 0.208 | 0.211 | 5 |

Denotation in Table 8 is in line with denotation in Tables 5 to 7. As can clearly be seen from Table 8 above, all the surface-coated cutting tools Nos. 141 to 144 according to the present invention had excellent wear resistance and toughness (there was no tool in which the second coating layer peeled off). In contrast, the surface-coated cutting tools Nos. 145 to 147 not having the first coating layer were poor in wear resistance and toughness, and a tendency of peeling of the second coating layer was shown.

Moreover, the surface-coated cutting tools Nos. 141 to 144 according to the present invention gave yellowish appearance as a whole, and the used state of the tool (which cutting-edge portion has already been used) could readily be recognized.

Though the embodiments and examples of the present invention have been described above, combination of embodiments and examples described above as appropriate is originally intended.

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

## Claims

1. A surface-coated cutting tool comprising:
a substrate; and
a coating layer formed on said substrate; wherein
said coating layer includes a first coating layer composed of titanium boronitride or titanium boron-oxynitride, and a second coating layer formed from at least one selected from the group consisting of aluminum oxide, zirconium oxide, hafnium oxide and a solid solution mainly including two or more of these components,
said first coating layer is located directly under said second coating layer, between said substrate and said second coating layer, and
said second coating layer has compressive stress at least in an area involved with cutting.

2. The surface-coated cutting tool according to claim 1, wherein
said coating layer has a third coating layer between said substrate and said first coating layer, and
said third coating layer is formed from a compound of at least one element selected from the group consisting of IVa-group elements, Va-group elements and VIa-group elements in periodic table, Al, and Si and at least one element selected from the group consisting of carbon, nitrogen, oxygen, and boron.

3. The surface-coated cutting tool according to claim 2, wherein
said third coating layer includes a titanium carbonitride layer formed with MT-CVD.

4. The surface-coated cutting tool according to claim 1, wherein
said first coating layer is composed of titanium boronitride expressed as TiB_{X}N_{Y}, where X and Y represent atomic % and relation of 0.001 <X/(X+Y)<0.04 is established.

5. The surface-coated cutting tool according to claim 1, wherein
said first coating layer is composed of titanium boron-oxynitride expressed as TiB_{X}N_{Y}O_{Z}, where X, Y and Z represent atomic % and relation of 0.0005<X/(X+Y+Z)<0.04 and 0<Z/(X+Y+Z)<0.5 is established.

6. The surface-coated cutting tool according to claim 1, wherein
said compressive stress is compressive stress of which absolute value is at least 0.2GPa.

7. The surface-coated cutting tool according to claim 1, wherein
said first coating layer has a thickness of at least 0.1µm to at most 3µm.

8. The surface-coated cutting tool according to claim 1, wherein
said coating layer has a thickness of at least 0.2µm to at most 30µm.

9. The surface-coated cutting tool according to claim 1, wherein
said second coating layer is composed of α-aluminum oxide.

10. The surface-coated cutting tool according to claim 1, wherein
said coating layer further includes a fourth coating layer, and
said fourth coating layer is formed on said second coating layer, in a portion excluding at least an area involved with cutting.

11. The surface-coated cutting tool according to claim 1, wherein
said substrate is formed from any one of cemented carbide, cermet, high-speed steel, ceramics, sintered cubic boron nitride, sintered diamond, sintered silicon nitride, and a mixture of aluminum oxide and titanium carbide.

12. The surface-coated cutting tool according to claim 1, being any one of a drill, an end mill, an insert for milling or turning, a metal saw, a gear cutting tool, a reamer, a tap, and an insert for crankshaft pin milling.
